# EUROPÄISCHE PATENTSCHRIFT

(11) **EP 1 023 622 B1**
(45) Veröffentlichungstag und Bekanntmachung des Hinweises auf die Patenterteilung: **28.01.2004**
(21) Anmeldenummer: 98958844.7
(22) Anmeldetag: 25.09.1998
(51) Int. Cl.: G02B 6/12

(54) **VORRICHTUNG ZUR WELLENLÄNGENSELEKTIVEN MISCHUNG UND/ODER VERTEILUNG VON POLYCHROMATISCHEM LICHT**
DEVICE FOR THE WAVELENGTH-SELECTIVE MIXTURE AND/OR DISTRIBUTION OF POLYCHROMATIC LIGHT
DISPOSITIF POUR LE MELANGE ET/OU LA REPARTITION, EN FONCTION DE LA LONGUEUR D'ONDE, DE LUMIERE POLYCHROMATIQUE

(30) Priorität: 14.10.1997 DE 19745324
(43) Veröffentlichungstag der Anmeldung: 02.08.2000
(73) Patentinhaber: Deutsche Telekom AG, 53113 Bonn (DE)
(72) Erfinder: KOOPS, Hans, Wilfried, Peter, D-64372 Ober-Ramstadt (DE); SHERIDAN, John, Dublin 14 (IE); ZÜRN, Martin, I-21020 Ispra (IT)
(86) Internationale Anmeldenummer: PCT/EP1998/006131
(87) Internationale Veröffentlichungsnummer: WO 1999/019754

(56) Entgegenhaltungen:
- DE-A- 2 903 288
- DE-A- 19 610 656
- DE-A- 19 634 893
- PATENT ABSTRACTS OF JAPAN vol. 096, no. 011, 29. November 1996 & JP 08 184730 A (FUJIKURA LTD), 16. Juli 1996
- KOOPS H W P: "PHOTONIC CRYSTALS BUILT BY THREE-DIMENSIONAL ADDITIVE LITHOGRAPHY ENABLE INTEGRATED OPTICS OF HIGH DENSITY" PROCEEDINGS OF THE SPIE, Bd. 2849, 5. August 1996, Seiten 248-256, XP000617864

## Beschreibung

Die Erfindung bezieht sich auf ein Verfahren der im Oberbegriff des Patentanspruchs 1 näher bezeichneten Art. Für ein derartiges Verfahren ist aus der DE 29 03 288 A ein optischer Multiplexer und Demultiplexer bekannt, das, basierend auf einem flachen optischen Filter, eine Kette wellenlängenselektiver Bauteile mit unterschiedlicher mittlerer Wellenlänge aufweist, an denen eingestrahltes polychromatisches Licht reflektiert und so zum nächsten Glied der selektiven Kette umgelenkt wird, wobei diese Glieder als Wellenlängenseparatoren in der Art eines Spektrometer verwendet werden.

Aus der AT&T Verlautbarung 7.96 ist bekannt, daß ein optisches Netz um Afrika herum aufgebaut wird, um mit 51 Wellenlängen die 51 Staaten getrennt zu versorgen. Hierzu werden die einzelnen Wellenlängen mit einer Art Spektrometer selektiv getrennt, die Informationen zurückgewonnen, und nach Sortierung der Informationen an verschiedene Verbraucher verteilt.

Für die Telekommunikation ist die wellenlängenselektive Mischung und/oder Verteilung von polychromatischem Licht im Wellenlängen Multiplex-Verfahren von Bedeutung, um das Wellenlängengemisch zu erzeugen und es wieder aufzulösen.

Multiplexer und Demultiplexer zur Zerlegung von polychromatischem Licht oder Lichtbündeln verschiedener vorgegebener Wellenlängen, wie sie bei der Telekommunikation verwendet werden, sind z. B. aus den EP 0 730 173 A1 und 0 651 529 A1 bekannt, wobei in jedem Glied einer selektiven Kette nacheinander jeweils Licht einer einzelnen Wellenlänge für die Mischung zur Bildung eines Teilspektrums zugeführt und zur Verteilung in jedem Glied eine Wellenlänge ausgefiltert wird.

Es ist in diesen Veröffentlichungen nicht näher ausgeführt, wie die räumliche Trennung der vorwärts und rückwärts laufenden Wellen realisiert werden soll und welcher Aufwand dafür in finanziellen und räumlichen Maßstäben zu treiben ist.

Aus DE 196 34 893 ist es auch bekannt elektrisch fein abstimmbare schmalbandige Filterelemente mittels eines photonischen Kristalls zu erzeugen, welches nur für eine eingestellte Wellenlänge durchlässig ist, während sie alle anderen Wellenlängen reflektieren.

Von Nachteil ist bei den bekannten Verfahren und Vorrichtungen, vor allem den Spektrometern, der hohe Aufwand für den erforderlichen exakten Aufbau und Abgleich.

Mit der Erfindung sollen diese benötigten Vorrichtungen wesentlich einfacher und kleiner gestaltet werden.

Diese Aufgabe wird mit dem im Kennzeichen des Patentanspruchs 1 aufgeführten Verfahren gelöst.

Vorteilhafte Weiterbildungsmöglichkeiten sind aus den Kennzeichen der Unteransprüche 2 bis 5 ersichtlich.
- Fig. 1: den Aufbau eines kaskadierten Spektrometers, das aus photonischen Kristallen aufgebaut ist und die vom Kristall spektral selektierte Lichtintensität mit einem Photowiderstand am Ausgang des Kristalls mißt,
- Fig. 2: den Aufbau für einen wellenlängenselektiven Demultiplexer, der aus einem Spektrum bestimmte Wellenlänge selektiv in Fasern einkoppelt und weiteren Netzwerken durch angekoppelte Fasern zuführt, und
- Fig. 3: den Aufbau für einen wellenlängenselektiven Multiplexer und Addierer, der zu einem Spektrum bestimmte Wellenlänge selektiv in Fasern einkoppelt und weiteren Netzwerken durch angekoppelte Fasern zuführt.

Wie bereits eingangs erwähnt, beruht die Problematik der wellenlängenselektiven Mischung und/oder Verteilung auf der möglichst einfachen und sicheren Selektion beim Zerlegen des Spektrums in mehrere spektral begrenzte Lichtstrahlen geringer Wellenlängenbreite, die auch maßgebendes Merkmal eines Spektrometers sind. Die weiteren Darlegungen gehen deshalb von der Anwendung für spektrometrische Messungen aus und führen zur kompletten Ausführung als Mischer und Verteiler.

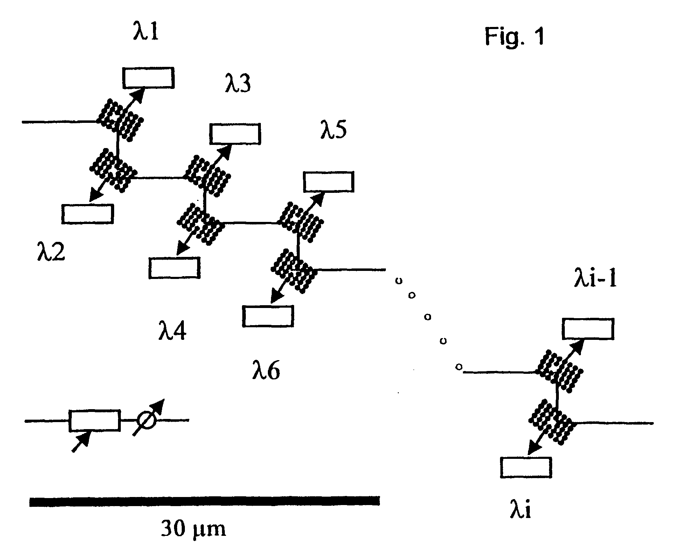

Unter Verwendung von Photonischen Kristallen, die in den DPA 195 33 148.6 und 196 28 355.8 beschrieben sind, kann entsprechend Fig. 1 auch ein Spektrometer aufgebaut werden, mit welchem die im Spektrum vorliegenden und die zu untersuchenden Wellenlängen spezifiziert selektiv ausgekoppelt und analysiert werden können. Dazu können für eine Meßanwendung als Spektrometer neben bekannten lichtempfindlichen Elementen herkömmlicher Bauart, wie Phototransistoren oder Charge coupled devices, oder Halbleiter-Dioden, vorteilhaft ein hochempfindlicher Photowiderstand aus nanokristallinem Material, entsprechend DPA 196 21 175.1 bzw. 197 20 926.2 eingesetzt werden.

Durch den Aufbau des Spektrometers aus photonischen Kristallen mit wellenlängenspezifischer Ausführung kann das Spektrometer zusammen mit dem das Licht detektierenden Element integriert auf einem Chip aufgebaut werden.

Damit stehen derartige Spektrometer auch für Umwelt-Überwachungsaufgaben an Emissionsquellen preiswert zur Verfügung. Diese können in Massenfertigung durch lithographische Verfahren mit durch Deposition hergestellten hochauflösenden Ätzmasken oder Korpuskularstrahlinduzierte Deposition im Projektionsgerät und mit durch Silylierung erzeugtem hohem Brechungsindex, entsprechend DPA 196 16 324.2, kommerziell hergestellt werden. Es ist derart ein "On-Chip"-Spektrometer realisierbar.

Je nach spezifizierter Wellenlänge können hier mit speziell aufgebauten selektiv wirkenden Filtern hoher Auflösung nur die Wellenlängen ausselektiert werden, die zur Weiterverarbeitung benötigt werden. Der Vorteil der Methode liegt in der geringen Baugröße und der hohen erzielbaren Selektivität in Intensität und Bandbreite.

Die Verwendung von Photonenkristallen in dieser Anordnung für diese Aufgabe ist bisher noch nicht bekannt. Der Einsatz zur Umweltüberwachung und für Wellenlängen-Digital-Multiplexing ist ebenfalls neu.

Ein solches Spektrometer aus Photonenkristallen zur Wellenlängen selektiven Strahlteilung ist integriert in ein Wellenleitermuster in der Art, daß stets pro Kristall eine Wellenlänge aus dem Gesamtspektrum ausgefiltert wird und das Restspektrum dem nächsten Kristall in der Kette durch hocheffiziente Reflexion zur weiteren Aufspaltung und Weitergabe zugeführt wird.

Am Ausgang eines jeden Spektrometerkristalles befindet sich in Fig. 1 zur Messung der Intensität ein hochempfindlicher Photowiderstand, integriert in die Anordnung oder ein herkömmlicher Detektor, in den das Licht aus dem Spektrometerkristall durch Wellenleiter oder Linsen eingekoppelt wird.

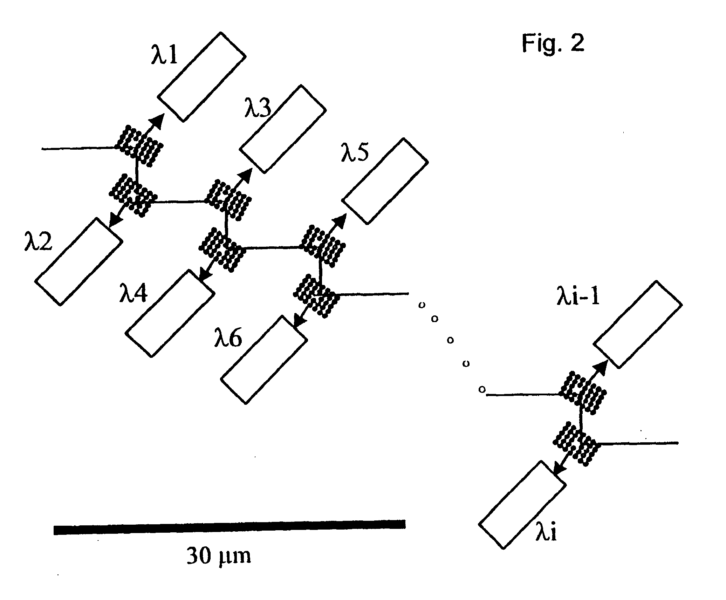

Ein solches Spektrometer kann, entsprechend Fig. 2, in der Ausführung mit photonischen Kristallen aus deponierten dielektrische Stangen mit ebenfalls deponiertem Widerstand durch Elektronenstrahlinduzierte Deposition erzeugt werden. Es kann aber auch in der Ausführung mit photonischen Kristallen aus durch Trocken-Ätzen hergestellten dielektrische Stangen mit deponiertem Widerstand, der durch Elektronenstrahlinduzierte Deposition hergestellt wird, erzeugen.

Eine weitere Möglichkeit für ein Spektrometer in der Ausführung mit photonischen Kristallen kann mit durch Trocken-Ätzen hergestellten Löchern in dielektrischer Materie und mit integriertem deponiertem Widerstand der durch Elektronenstrahlinduzierte Deposition erzeugt wurde.

Die beschriebenen Spektrometer mit photonischen Kristallen können jeweils mit pro Spektralkanal angeschlossener optischer Faser entsprechend Fig. 2 zur Wellenlängen -Aufteilung des Spektrums einer Viel-wellenlängen-Übertragangsstrecke komplettiert werden. Dieses Bauteil kann auch für einzelne Wellenlängen als Mischer (Add) und als Verteiler (Drop) eingesetzt werden.

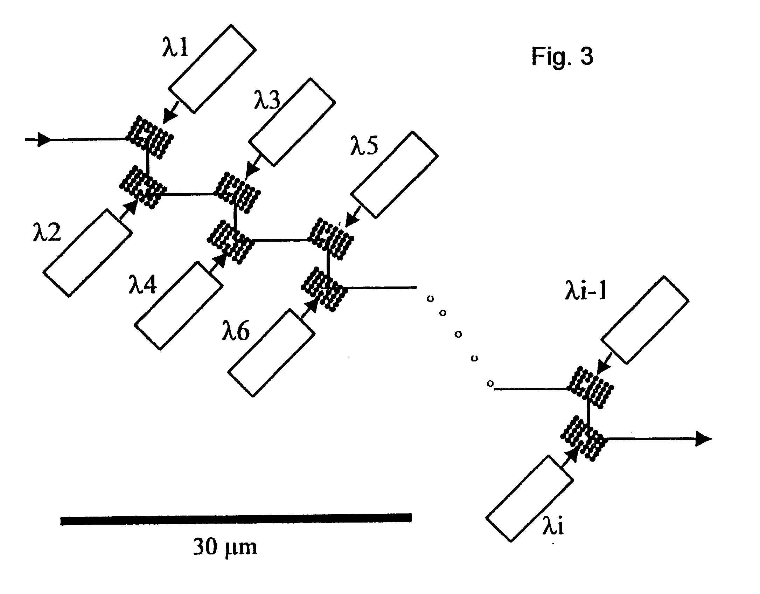

Ein Synthetisierer entsteht, entsprechend Fig. 3, durch die Abwandlung eines solchen Spektrometers, das aus Photonenkristallen zur wellenlängenselektiven Strahlteilung besteht, integriert in ein Wellenleitermuster in der Anordnung, dadurch, daß stets pro Kristall eine Wellenlänge aus dem Gesamtspektrum ausgefiltert wird und das Restspektrum dem nächsten Kristall in der Kette durch hocheffiziente Reflexion zur weiteren Aufspaltung und Weitergabe zugeführt wird.

In umgekehrter Richtung, als Synthetisierer zum Zusammensetzen eines Spektrums aus einzelnen Laserwellenlängen, werden die selben Elemente des Spektrometers betrieben. Am Ausgang eines jeden Spektrometerkristalles befindet sich zur Einkopplung des Lichtes der bestimmten Wellenlänge ein Faserlaser oder Laseranschluß, mit welchem auf kleinstem Raum das Spektrum komponiert werden kann.

Ein solcher Synthetisierer (ADD) kann, mit angeschlossener optischer Faser mit pro Spektralkanal, zur Wellenlängen-Komposition eines Spektrums mit einer oder mehreren weiteren Wellenlängen verwendet werden, die zu einer viel-Wellenlängen-Übertragungsstrecke hinzugefügt werden sollen, ohne das Spektrum der Strecke zu beeinflussen.

## Patentansprüche

1. Vorrichtung zur wellenlängenselektiven Mischung und/oder Verteilung von polychromatischem Licht, in der gebündeltes Licht unterschiedlicher Wellenlängen zu einem Spektrum zusammengefaßt, übertragen und danach wieder mittels seriell angeordneter selektiver Mittel, nachfolgend als Wellenlängenseparatoren bezeichnet, spektrometrisch getrennt wird, bei der für eine Mischung jedem Glied einer selektiven Kette von Wellenlängenseparatoren nacheinander jeweils Licht einer einzelnen Wellenlänge zur Bildung eines Teilspektrums zugeführt ist und für eine Verteilung in jedem Glied der selektiven Kette polychromatisches Licht reflektiert und derart zum nächsten Glied der selektiven Kette umgelenkt ist, daß jedes Glied eine Wellenlänge aus dem polychromatischen Licht ausfiltert, **dadurch gekennzeichnet, daß** alle Glieder der Kette von Wellenlängenseparatoren als Bestandteile einer integrierten photonischen Kristallstruktur ausgebildet sind, wobei die Glieder jeweils ebenfalls Wellenlängenselektive integrierte Ein-/Auskoppler umfassen, daß die Glieder das jeweilige Restspektrum nach wellenlängenselektiver, Reflexion innerhalb des photonischen Kristallmaterials dem nächsten Glied der Kette zur weiteren Aufspaltung zuführen, und daß jedes Glied der Kette, das nicht reflektierte selektierte Licht umlenkt.

2. Vorrichtung nach Anspruch 1, **dadurch gekennzeichnet, daß** zur universellen Verwendung, auch als Spektrometer, jeder Ein-/Auskoppler eine Verbindung für eine optische Faser, Faserlaser, bzw. Laseranschluß besitzt und jedem der Glieder ein Detektor in Form eines integrierten Photowiderstandes zur Messung der Intensität zugeordnet ist.

3. Vorrichtung nach Anspruch 1 und 2, **dadurch gekennzeichnet, daß** die Kette von Gliedern in photonischen Kristallen aus deponierten dielektrischen Stangen mit ebenfalls deponiertem Photowiderstand durch elektronenstrahlinduzierte Deposition erzeugt ist.

4. Vorrichtung nach Anspruch 1 bis 3, **dadurch gekennzeichnet, daß** die Kette von Gliedern in photonischen Kristallen aus durch Trocken-Ätzen hergestellten dielektrischen Stangen besteht, mit deponiertem Photowiderstand, der durch elektronenstrahlinduzierte Deposition erzeugt ist.

5. Vorrichtung nach Anspruch 1 bis 4, **dadurch gekennzeichnet, daß** die Kette von Gliedern in photonischen Kristallen aus durch Trocken-Ätzen hergestellten Löchern in dielektrischer Materie besteht, mit integriertem deponierten Photowiderstand, der durch elektronenstrahlinduzierte Deposition erzeugt ist.

## Claims

1. Device for the wavelength-selective mixing and/or distribution of polychromatic light, wherein bundled light of different wavelengths is combined into a spectrum, transmitted and then spectrometrically separated again by means of serially disposed selective means, hereinafter referred to as wavelength separators, wherein, for mixing, each link of a selective chain of wavelength separators is successively supplied with light of a single wavelength to form a subspectrum and, for distribution, in each link of the selective chain polychromatic light is reflected and deflected in such a manner to the next link of the selective chain that each link filters out one wavelength from the polychromatic light, **characterized in that** all the links of the chain of wavelength separators are in the form of constituent parts of an integrated photonic crystal structure, the links each likewise comprising wavelength-selective integrated in-/outcouplers, the links supplying the respective residual spectrum after wavelength-selective reflection within the photonic crystal material to the next link of the chain for further splitting, wherein each link of the chain deflects the non-reflected selected light.

2. Device according to claim 1, **characterized in that**, for general-purpose use, including as a spectrometer, each in-/outcoupler has a connection for an optical fibre, fibre laser or laser connection and each of the links is associated with a detector in the form of an integrated photoresistor for measuring the intensity.

3. Device according to claims 1 and 2, **characterized in that** the chain of links is produced in photonic crystals of deposited dielectric rods with likewise deposited photoresistor by means of electron-beam-induced deposition.

4. Device according to claims 1 to 3, **characterized in that** the chain of links in photonic crystals consists of dielectric rods made by dry etching, with deposited photoresistor produced by electron-beam-induced deposition.

5. Device according to claims 1 to 4, **characterized in that** the chain of links in photonic crystals consists of holes in dielectric matter made by dry etching, with integrated deposited photoresistor produced by electron-beam-induced deposition.

## Revendications

1. Dispositif de mélange et/ou distribution, sélectifs en longueur d'onde, de lumière polychromatique, dans lequel de la lumière focalisée de différentes longueurs d'onde est rassemblée en un spectre, transmise, puis à nouveau décomposée spectrométriquement à l'aide de moyens sélectifs disposés en série, appelés ci-après séparateurs de longueurs d'onde, le mélange étant opéré en diffusant successivement sur chaque maillon d'une chaîne sélective de séparateurs de longueurs d'onde de la lumière d'une seule longueur d'onde pour former un spectre partiel et la distribution étant opérée en réfléchissant de la lumière polychromatique dans chaque maillon de la chaîne sélective et en la déviant sur le maillon suivant de la chaîne sélective de telle façon que chaque maillon extrait une longueur d'onde de la lumière polychromatique, **caractérisé en ce que** tous les maillons de la chaîne de séparateurs de longueurs d'onde font partie d'une structure photonique cristalline intégrée, les maillons comprenant également des éléments intégrés d'activation/désactivation, sélectifs en longueur d'onde, **en ce que** les maillons transmettent le reste du spectre, pour en poursuivre la décomposition, au maillon suivant de la chaîne après réflexion sélective en longueur d'onde à l'intérieur du matériau photonique cristallin et **en ce que** chaque maillon de la chaîne dévie la lumière sélectionnée, non réfléchie.

2. Dispositif selon la revendication 1, **caractérisé en ce que**, aux fins d'une utilisation universelle, aussi comme spectromètre, chaque élément d'activation/désactivation comprend une connexion pour une fibre optique, un laser à fibre ou un raccordement laser et **en ce que** à chaque maillon correspond un détecteur sous forme de résistance photoélectrique intégrée pour mesurer l'intensité.

3. Dispositif selon les revendications 1 et 2, **caractérisé en ce que** la chaîne de maillons en cristaux photoniques est formée par déposition induite par rayon électronique à partir de barres diélectriques déposées avec résistance photoélectrique également déposée.

4. Dispositif selon les revendications 1 à 3, **caractérisé en ce que** la chaîne de maillons en cristaux photoniques est constituée de barres diélectriques produites par gravure à sec, avec résistance photoélectrique déposée, constituée par déposition induite par rayon électronique.

5. Dispositif selon les revendications 1 à 4, **caractérisé en ce que** la chaîne de maillons en cristaux photoniques est constituée de trous produits par gravure à sec dans une matière diélectrique, avec résistance photoélectrique déposée, constituée par déposition induite par rayon électronique
